# EUROPÄISCHE PATENTSCHRIFT

(11) **EP 4 536 582 B1**
(45) Veröffentlichungstag und Bekanntmachung des Hinweises auf die Patenterteilung: **08.07.2026**
(21) Anmeldenummer: 23726886.7
(22) Anmeldetag: 08.05.2023
(51) Int. Cl.: B81C 1/00

(54) **GEHÄUSE MIT EINEM MIKROMECHANISCHEN BAUTEIL**
HOUSING COMPRISING A MICROMECHANICAL COMPONENT
BOÎTIER COMPRENANT UN COMPOSANT MICROMÉCANIQUE

(30) Priorität: 30.05.2022 DE 102022205388
(43) Veröffentlichungstag der Anmeldung: 16.04.2025
(73) Patentinhaber: Robert Bosch GmbH, 70442 Stuttgart (DE)
(72) Erfinder: JEMILI, Amin, 72172 Kusterdingen (DE); REINMUTH, Jochen, 72766 Reutlingen (DE); HAAG, Frieder, 72827 Wannweil (DE)
(86) Internationale Anmeldenummer: PCT/EP2023/062143
(87) Internationale Veröffentlichungsnummer: WO 2023/232394

(56) Entgegenhaltungen:
- US-A1- 2015 001 651
- US-A1- 2017 374 474
- US-A1- 2019 233 278

## Beschreibung

Die Erfindung betrifft eine Halbleitervorrichtung mit einem mikromechanischen Bauteil. Ebenso betrifft die Erfindung ein Herstellungsverfahren für eine Halbleitervorrichtung.

### Stand der Technik

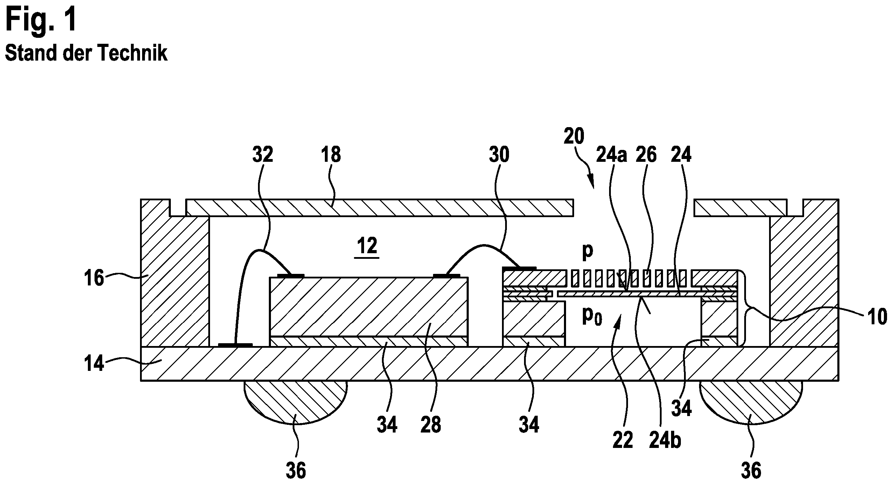

Fig. 1 zeigt eine schematische Darstellung eines herkömmlichen Drucksensors, welcher der Anmelderin als interner Stand der Technik bekannt ist.

Der in Fig. 1 schematisch dargestellte herkömmliche Drucksensor hat ein mikromechanisches Bauteil 10, welches in einem Innenraum 12 eines von einer Bodenplatte 14, einem an der Bodenplatte 14 befestigten Seitenteil 16 und einem an dem Seitenteil 16 befestigten Deckel 18 gebildeten Gehäuses angeordnet ist. Der Deckel 18 weist eine Zufuhröffnung 20 auf, weshalb ein in dem Innenraum 12 vorliegender Druck p einem Umgebungsdruck des herkömmlichen Drucksensors entspricht, während in einem Innenvolumen 22 des mikromechanischen Bauteils 10 ein Referenzdruck p₀ eingesperrt ist.

Das mikromechanische Bauteil 10 ist mit einer verwölbbaren Membran 24 ausgebildet, auf deren erste Membranoberfläche 24a der Druck p in dem Innenraum 12 einwirkt, während eine von der ersten Membranoberfläche 24a weg gerichtete zweite Membranoberfläche 24b der verwölbbaren Membran 24 an das Innenvolumen 22 mit dem darin vorliegenden Referenzdruck p₀ angrenzt. Anhand einer zwischen der verwölbbaren Membran 24 und einer zugeordneten Gegenelektrode 26 anliegenden Spannung oder Kapazität soll eine Druckdifferenz zwischen dem Druck p in dem Innenraum 12 und dem Referenzdruck p₀ messbar sein.

In dem Innenraum 12 ist auch eine anwendungsspezifische Schaltung 28 angeordnet, welche über eine erste Bonddrahtverbindung 30 an dem mikromechanischen Bauteil 10 und über eine zweite Bonddrahtverbindung 32 an dem Gehäuse des herkömmlichen Drucksensors elektrisch angebunden ist. Das mikromechanische Bauteil 10 und die anwendungsspezifische Schaltung 28 können beispielsweise über je eine Klebeverbindung 34 an der Bodenplatte 14 festgeklebt sein. Außerdem weist der herkömmliche Drucksensor noch Lötbälle 36 auf einer von dem Innenraum 12 weg gerichteten Unterseite der Bodenplatte 14 auf. US 2019/233278 A1 offenbart ein elektromechanisches Drucksensorsystem mit einem mikroelektromechanischen Wandler. Das Drucksensorsystem umfasst ein Substrat aus Polymermaterial mit einem Durchgangsloch, in dem der mikroelektromechanische Wandler angeordnet ist. Das Durchgangsloch besitzt zwei unterschiedlich große Durchmesser, so dass eine Schulter entsteht, die eine Auflagezone für den mikroelektromechanischen Wandler bildet. Eine Kappe formt einen rückwärtigen Hohlraum für den mikroelektromechanischen Wandler.

### Offenbarung der Erfindung

Die Erfindung schafft eine Halbleitervorrichtung mit den Merkmalen des Anspruchs 1 und ein Herstellungsverfahren für eine Halbleitervorrichtung mit den Merkmalen des Anspruchs 9.

### Vorteile der Erfindung

Die vorliegende Erfindung schafft Halbleitervorrichtungen, welche durch Ausführen eines stark parallelisierten Herstellungsprozesses unter Verwendung standardgemäßer Halbleitertechnologien kostengünstig hergestellt werden können. Wie anhand der nachfolgenden Beschreibung außerdem deutlich wird, weist eine erfindungsgemäße Halbleitervorrichtung einen vergleichsweise robusten Aufbau auf, bei welchem insbesondere das Risiko einer Bildung von akustischen Leckpfaden zuverlässig vermieden ist. Die vorliegende Erfindung trägt somit dazu bei, für eine Vielzahl von Halbleitervorrichtungen die Ausbeute ihres Herstellungsprozesses zu steigern.

Bei einer vorteilhaften Ausführungsform der Halbleitervorrichtung weist das mikromechanische Bauteil zumindest ein strukturiertes oder unstrukturiertes Substrat auf, das mindestens ein Halbleitermaterial umfasst, wobei das mikromechanische Bauteil derart in der durchgehenden Öffnung angeordnet ist, dass mindestens eine Außenfläche des zumindest einen Substrats des mikromechanischen Bauteils die mindestens eine Seitenwand der durchgehenden Öffnung mechanisch kontaktiert. Die mindestens eine Außenfläche des Substrats des mikromechanischen Bauteils kann damit kostengünstiger Weise als Kontaktfläche des Spritzgusskörpers genutzt werden. Dies ist vorteilhaft, da die den Spritzgusskörper bildende Moldmasse sich auf einfache Weise mittels eines Umspritzens des mikromechanischen Bauteils in einen festen mechanischen Kontakt mit der mindestens einen Außenfläche des zumindest einen Substrats, insbesondere in einen luft- und gasdichten mechanischen Kontakt mit der mindestens einen Außenfläche des zumindest einen Substrats, bringen lässt. Der auf diese Weise gebildete mechanische Kontakt der mindestens einen Seitenwand der durchgehenden Öffnung mit der mindestens einen Außenfläche des Substrats weist außerdem in der Regel eine relativ lange Beständigkeit/Lebensdauer auf.

Vorzugsweise ist die Aussparung auf ihrer ersten Seite von dem Bodenbereich des Spritzgusskörpers und von dem in der durchgehenden Öffnung angeordneten mikromechanischen Bauteil abgedeckt. Damit ist mittels der luft- und gasdichten Ausbildung des mechanischen Kontakts der mindestens einen Seitenwand der durchgehenden Öffnung mit dem mikromechanischen Bauteil auch das Risiko eines Auftretens eines akustischen Leckpfades an der ersten Seite der Aussparung unterbunden.

Bevorzugter Weise ist der Deckel luft- und gasdicht direkt oder über die mindestens eine Zwischenkomponente an dem Seitenwandbereich befestigt ist und der mechanische Kontakt der mindestens einen Seitenwand der durchgehenden Öffnung mit dem mikromechanischen Bauteil ist luft- und gasdicht, wodurch die Aussparung mittels des Spritzgusskörpers, des Deckels und des mikromechanischen Bauteils luft- und gasdicht gegenüber einem Außenvolumen der Halbleitervorrichtung abgedichtet ist. Ein Gesamtvolumen der Aussparung kann in diesem Fall als Referenzvolumen zur Bereitstellung eines Referenzdrucks genutzt werden, wobei aufgrund des vergleichsweise großen Gesamtvolumens der Aussparung unter Verwendung des mikromechanischen Bauteils der hier beschriebenen Ausführungsform Druck- und Schalldetektionen mit einer relativ hohen Empfindlichkeit möglich sind.

Beispielsweise kann das in der durchgehenden Öffnung angeordnete mikromechanische Bauteil mindestens eine verwölbbare Membran aufweisen, auf deren jeweilige erste Membranoberfläche ein in dem Außenvolumen vorherrschender Druck und auf deren von der ersten Membranoberfläche weg gerichtete jeweilige zweite Membranoberfläche ein in der Aussparung eingeschlossener Referenzdruck einwirken. Aufgrund des vergleichsweise großen Gesamtvolumens der Aussparung baut sich selbst bei einer starken Verwölbung der Membran (nahezu) kein der Verwölbung entgegenwirkender Gegendruck auf, weshalb mittels der hier beschriebenen Ausführungsform der Halbleitervorrichtung Druck- und Schalldetektionen mit einer relativ hohen Empfindlichkeit möglich sind.

Als vorteilhafte Weiterbildung kann das in der durchgehenden Öffnung angeordnete mikromechanische Bauteil an seinem zu der Aussparung ausgerichteten Ende einen Abstandshalter aufweisen, wobei mindestens eine Abstandshalterseitenfläche des Abstandshalters die mindestens eine Seitenwand der durchgehenden Öffnung mechanisch kontaktiert. Dies erlaubt eine Positionierung mindestens einer empfindlichen Komponente des mikromechanischen Bauteils beabstandet von einem an die Aussparung angrenzenden Rand der durchgehenden Öffnung in dem Bodenbereich des Spritzgusskörpers, wodurch das Risiko eines unerwünschten Kontakts der Positionierung der mindestens einen empfindlichen Komponente des mikromechanischen Bauteils mit der Moldmasse des zu bildenden Spritzgusskörpers signifikant reduziert ist. Das mikromechanische Bauteil der hier beschriebenen Ausführungsform kann deshalb auch mindestens eine sehr empfindliche Membran aufweisen, ohne dass deren Beschädigung während der Herstellung der jeweiligen Halbleitervorrichtung zu befürchten ist.

Alternativ oder ergänzend kann das in der durchgehenden Öffnung angeordnete mikromechanische Bauteil eine anwendungsspezifische Schaltungseinrichtung aufweisen, wobei mindestens eine Seitenfläche der anwendungsspezifischen Schaltungseinrichtung die mindestens eine Seitenwand der durchgehenden Öffnung mechanisch kontaktiert. Das hier beschriebene Design erleichtert eine Integration der anwendungsspezifischen Schaltungseinrichtung in das mikromechanische Bauteil.

Die Halbleitervorrichtung kann beispielsweise ein Drucksensor, ein Schallsensor oder ein Mikrofon sein. Es wird jedoch darauf hingewiesen, dass die hier aufgezählten Ausführungsformen der Halbleitervorrichtung nicht abschließend zu interpretieren sind.

Auch ein Ausführen eines korrespondierenden Herstellungsverfahrens für eine Halbleitervorrichtung schafft die vorausgehend erläuterten Vorteile. Es wird darauf hingewiesen, dass das Herstellungsverfahren gemäß den oben erläuterten Ausführungsformen der Halbleitervorrichtung weitergebildet werden kann.

Vorzugsweise wird zum Bilden des Spritzgusskörpers das mikromechanische Bauteil unter Verwendung eines Stempels mit einer Moldmasse des späteren Spritzgusskörpers umspritzt. Mittels des Stempels kann sichergestellt werden, dass eine gewünschte Form des späteren Spritzgusskörpers gut eingehalten wird.

Insbesondere kann vor dem Umspritzen des mikromechanischen Bauteils mit der Moldmasse des späteren Spritzgusskörpers ein Film zwischen dem Stempel und dem mikromechanischen Bauteil angeordnet werden, welcher nach dem Umspritzen des mikromechanischen Bauteils mit der Moldmasse und einem Abnehmen des Stempels von dem umspritzten mikromechanischen Bauteil entfernt wird. Mittels der Verwendung des Films kann ein vorteilhafter Toleranzausgleich erzielt werden.

### Kurze Beschreibung der Zeichnungen

Weitere Merkmale und Vorteile der vorliegenden Erfindung werden nachfolgend anhand der Figuren erläutert. Es zeigen:
- Fig. 1: eine schematische Darstellung eines herkömmlichen Drucksensors;
- Fig. 2: eine schematische Darstellung einer ersten Ausführungsform der Halbleitervorrichtung;
- Fig. 3: eine schematische Darstellung einer zweiten Ausführungsform der Halbleitervorrichtung;
- Fig. 4: eine schematische Darstellung einer dritten Ausführungsform der Halbleitervorrichtung; und
- Fig. 5a bis 5f: schematische Darstellungen von Zwischenprodukten zum Erläutern einer Ausführungsform des Herstellungsverfahrens für eine Halbleitervorrichtung.

### Ausführungsformen der Erfindung

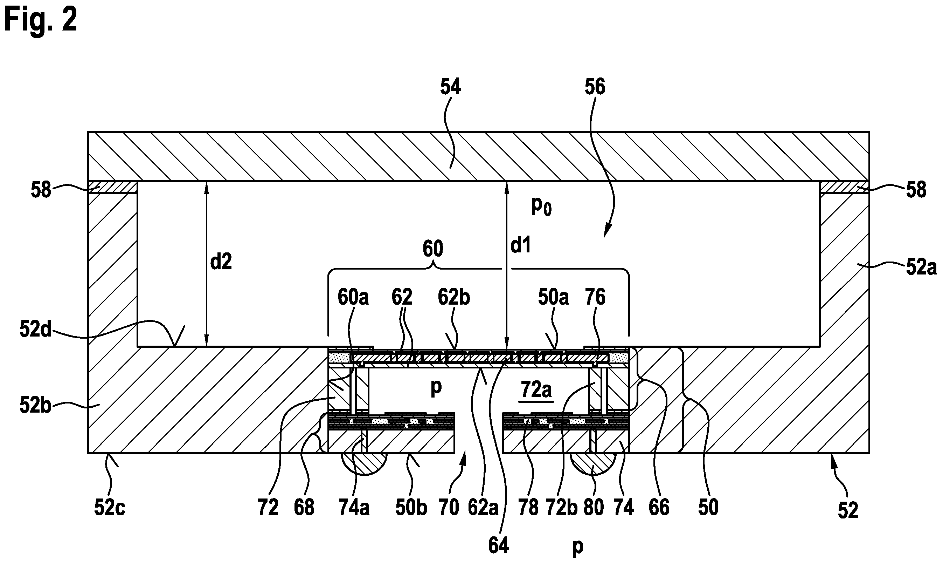

Fig. 2 zeigt eine schematische Darstellung einer ersten Ausführungsform der Halbleitervorrichtung.

Die in Fig. 2 schematisch wiedergegebene Halbleitervorrichtung umfasst ein mikromechanisches Bauteil 50, einen Spritzgusskörper 52 und einen Deckel 54. An dem Spritzgusskörper 52 ist zumindest eine Aussparung 56 ausgebildet, welche von einem sogenannten Seitenwandbereich 52a des Spritzgusskörpers 52 umrahmt ist und auf einer ersten Seite der Aussparung 56 zumindest teilflächig von einem sogenannten Bodenbereich 52b des Spritzgusskörpers 52 abgedeckt ist. Es wird darauf hingewiesen, dass unter dem Spritzgusskörper 52 vorzugsweise ein kompakt ausgebildeter Körper aus einer Moldmasse zu verstehen ist, an welchem der Seitenwandbereich 52a und der Bodenbereich 52b einstückig miteinander ausgebildet sind. Der Spritzgusskörper 52 kann in einem einzigen Spritzgussschritt aus der Moldmasse geformt sein. Die an dem Spritzgusskörper 52 ausgebildete Aussparung 56 erstreckt sich zumindest von ihrer ersten Seite bis zu zumindest einer von der ersten Seite weg gerichteten zweiten Seite der Aussparung 56. Der Deckel 54 ist auf der zweiten Seite der Aussparung 56 direkt oder über mindestens eine Zwischenkomponente 58 an dem Seitenwandbereich 52a befestigt. Unter der ersten Seite der Aussparung 56 ist somit eine von dem Deckel 54 weg gerichtete Seite/"Bodenbereichseite" der Aussparung 56 zu verstehen, während die zweite Seite der Aussparung 56 als eine "Deckelseite" bezeichnet werden kann.

Der Deckel 54 deckt die Aussparung 56 (vorzugsweise vollständig) auf ihrer zweiten Seite ab. Der Deckel 54 kann auch als eine Kappe 54 oder als eine Verkappung 54 der Halbleitervorrichtung bezeichnet werden. Die mindestens eine Zwischenkomponente 58 kann z.B. eine Klebeverbindung oder eine Mold-Verbindung 58 sein. Lediglich beispielhaft ist bei der Ausführungsform der Fig. 2 der Deckel 54 über eine sogenannte Sheet-Mold-Verbindung 58 an dem Seitenwandbereich 52a des Spritzgusskörpers 52 befestigt.

Wie in Fig. 2 erkennbar ist, ist an dem Bodenbereich 52b des Spritzgusskörpers 52 eine durchgehende Öffnung 60 ausgebildet. Die durchgehende Öffnung 60 ist von dem Bodenbereich 52b des Spritzgusskörpers 52 umrahmt. Mindestens eine Seitenwand 60a der durchgehenden Öffnung 60 erstreckt sich von der Aussparung 56 bis zu einer von der Aussparung 56 weg gerichteten Bodenaußenfläche 52c des Bodenbereichs 52b. Das mikromechanische Bauteil 50 ist derart in der durchgehenden Öffnung 60 angeordnet, dass das mikromechanische Bauteil 50 die mindestens eine Seitenwand 60a der durchgehenden Öffnung 60 mechanisch kontaktiert.

Bei der hier beschriebenen Halbleitervorrichtung ist das mikromechanische Bauteil 50 somit zumindest teilweise in den Bodenbereich 52b des Spritzgusskörpers 52 integriert. Die Anordnung des mikromechanischen Bauteils 50 an der Halbleitervorrichtung kann somit in einem gemeinsamen Verfahrensschritt mit dem Bilden des Spritzgusskörpers 52 erfolgen. Ein zusätzlicher Verfahrensschritt zum Platzieren des mikromechanischen Bauteils 50 an/in dem Spritzgusskörper 52 nach dem Bilden des Spritzgusskörpers 52, wie beispielsweise das herkömmliche Festkleben des mikromechanischen Bauteils 50 an/in dem Spritzgusskörper 52, ist damit zum Herstellen der hier beschriebenen Halbleitervorrichtung nicht notwendig. Die Halbleitervorrichtung der Fig. 2 ist deshalb vergleichsweise kostengünstig herstellbar.

Für den Bodenbereich 52b des Spritzgusskörpers 52 kann eine von seiner Bodenaußenfläche 52c weg gerichtete Bodeninnenfläche 52d definierbar sein, welche in einem maximalen Abstand zu dem Deckel 54 an der Aussparung 56 angrenzt. Ebenso kann für das mikromechanische Bauteil 50 eine Bauteiloberfläche 50a definierbar sein, welche zu der Aussparung 56 ausgerichtet ist und von allen Oberflächen des mikromechanischen Bauteils 50 den kleinsten Abstand zu dem Deckel 54 aufweist. Vorzugsweise ist ein erster Abstand d1 der Bauteiloberfläche 50a des mikromechanischen Bauteils 50 von dem Deckel 54 größer-gleich einem zweiten Abstand d2 der Bodeninnenfläche 52d des Bodenbereichs 52b von dem Deckel 54. Das mikromechanische Bauteil 50 ist in diesem Fall vollständig in den Bodenbereich 52b des Spritzgusskörpers 52 integriert/versenkt. Die in dem Spritzgusskörper 52 ausgebildete Aussparung 56 wird somit nicht als Aufnahmevolumen des mikromechanischen Bauteils 50 benötigt, so dass deshalb ein Gesamtvolumen der Aussparung 56 vorteilhaft für andere Verwendungszwecke genutzt werden kann.

Die Aussparung 56 kann auf ihrer (von dem Deckel 54 weg gerichteten) ersten Seite von dem Bodenbereich 52b des Spritzgusskörpers 52 und von dem in der durchgehenden Öffnung 60 angeordneten mikromechanischen Bauteil 50 (vollständig) abgedeckt sein. Dies ist vorteilhaft, weil der mechanische Kontakt der mindestens einen Seitenwand 60a der durchgehenden Öffnung 60 mit dem mikromechanischen Bauteil 50 während des Spritzgussgießens des Spritzgusskörpers 52 auf einfache Weise luft- und gasdicht ausbildbar ist. Auch der Deckel 54 ist auf einfache Weise luft- und gasdicht direkt oder über die mindestens eine Zwischenkomponente 58 an dem Seitenwandbereich 52a des Spritzgusskörpers 52 befestigbar. Die Aussparung 56 kann deshalb unter Aufbringung eines vergleichsweise geringen Arbeitsaufwands mittels des Spritzgusskörpers 52, des Deckels 54 und des mikromechanischen Bauteils 50 luft- und gasdicht gegenüber einem Außenvolumen der Halbleitervorrichtung abgedichtet werden.

Vorzugsweise ist die Aussparung 56 mittels des Spritzgusskörpers 52, des Deckels 54 und des mikromechanischen Bauteils 50 gegenüber dem Außenvolumen der Halbleitervorrichtung luft- und gasdicht abgedichtet. Der Spritzgusskörper 52, der Deckel 54 und das mikromechanische Bauteil 50 bilden in diesem Fall ein luft- und gasdichtes Gehäuse der Aussparung 56, welches einen robusten Aufbau aufweist und bei welchem das Risiko einer Bildung von akustischen Leckpfaden vergleichsweise gering ist. Die mit dem mikromechanischen Bauteil 50 und der luft- und gasdichten Aussparung 56 ausgestattete Halbleitervorrichtung kann deshalb vielseitig eingesetzt werden.

Lediglich beispielhaft ist die Halbleitervorrichtung der Fig. 2 als Drucksensor/kapazitiver Drucksensor, als Schallsensor, wie insbesondere als Körperschallsensor, oder als Mikrofon ausgebildet. Dazu weist das in der durchgehenden Öffnung 60 angeordnete mikromechanische Bauteil 50 mindestens eine verwölbbare Membran 62 auf, welche jeweils zusammen mit mindestens einer Gegenelektrode 64 des mikromechanischen Bauteils 50 derart elektrisch kontaktierbar ist, dass eine zwischen der mindestens einen verwölbbaren Membran 62 und der mindestens einen Gegenelektrode 64 anliegende Spannung oder Kapazität abgreifbar/ermittelbar ist. Je eine erste Membranoberfläche 62a der mindestens einen verwölbbaren Membran 62 ist derart von der Aussparung 56 weg gerichtet, dass ein in dem Außenvolumen der Halbleitervorrichtung vorherrschender Druck p auf die erste Membranoberfläche 62a einwirkt. Demgegenüber ist je eine von der ersten Membranoberfläche 62a weg gerichtete zweite Membranoberfläche 62b derart zu der Aussparung 56 ausgerichtet, dass ein in der Aussparung 56 eingeschlossener Referenzdruck p₀ auf die zweite Membranoberfläche 62b einwirkt. Die Aussparung 56 kann somit bei der Halbleitervorrichtung der Fig. 2 als Referenzvolumen für den Referenzdruck p₀ genutzt werden, wobei aufgrund des vergleichsweise großen Gesamtvolumens der Aussparung 56 selbst bei einer starken Einwölbung der mindestens einen verwölbbaren Membran 62 in die Aussparung 56 kaum ein Druckaufbau in der Aussparung 56 auftritt. Damit führt die Einwölbung der mindestens einen Membran 62 in die Aussparung 56 auch nicht zu einem der Einwölbung entgegenwirkenden Gegendruck in der Aussparung 56. Wie in Fig. 2 erkennbar ist, kann das Gesamtvolumen der Aussparung 56 zumindest um einen Faktor 2 größer als ein Gesamtvolumen des mikromechanischen Bauteils 50 sein. Ein derart großes Referenzvolumen für den Referenzdruck p₀ trägt zur Steigerung einer Empfindlichkeit der als Drucksensor, Schallsensor oder als Mikrofon genutzten Halbleitervorrichtung bei.

Es wird jedoch darauf hingewiesen, dass die mindestens eine verwölbbare Membran 62 und die mindestens eine Gegenelektrode 64 nur Beispiele für mögliche Komponenten einer mikromechanischen Einrichtung 66 des mikromechanischen Bauteils 50 sind. Als Alternative oder als Ergänzung zu den Komponenten 64 und 66 kann die mikromechanische Einrichtung 66 des mikromechanischen Bauteils 50 auch mindestens eine seismische Masse, mindestens eine Aktorelektrode und/oder mindestens eine Statorelektrode umfassen. Mindestens eine Seitenwand der mikromechanischen Einrichtung 66 kann einen mechanischen Kontakt mit der mindestens einen Seitenwand 60a der durchgehenden Öffnung 60 haben. Evtl. kann auf die Ausbildung der mikromechanischen Einrichtung 66 an dem mikromechanischen Bauteil 50 jedoch auch verzichtet sein.

Vorteilhafterweise weist das in der durchgehenden Öffnung 60 angeordnete mikromechanische Bauteil 50 der Halbleitervorrichtung der Fig. 2 auch eine anwendungsspezifische Schaltungseinrichtung 68 auf. In diesem Fall kann mindestens eine Seitenfläche der anwendungsspezifischen Schaltungseinrichtung 68 die mindestens eine Seitenwand 60a der durchgehenden Öffnung 60 mechanisch kontaktieren. Damit entfällt auch die herkömmliche Notwendigkeit zum Platzieren einer getrennt von dem mikromechanischen Bauteil 50 ausgebildeten anwendungsspezifischen Schaltung an/in dem Spritzgusskörper 52 nach dem Bilden des Spritzgusskörpers 52 und zum Ausbilden einer elektrischen Anbindung des mikromechanischen Bauteils 50 an die getrennt davon ausgebildete anwendungsspezifische Schaltung über mindestens eine Bonddrahtverbindung. Dies reduziert den zur Herstellung der Halbleitervorrichtung zu leistenden Arbeitsaufwand zusätzlich. Außerdem wird in diesem Fall das Gesamtvolumen der Aussparung nicht durch die anwendungsspezifische Schaltungseinrichtung 68 beeinträchtigt.

Wie in Fig. 2 erkennbar ist, kann die anwendungsspezifische Schaltungseinrichtung 68 auch auf einer von der Aussparung 56/von dem Deckel 54 weg gerichteten Seite der mikromechanischen Einrichtung 66, speziell der mindestens einen verwölbbaren Membran 62, des in der durchgehenden Öffnung 60 angeordneten mikromechanischen Bauteil 50 liegen. Mittels mindestens einer sich jeweils durch die anwendungsspezifischen Schaltungseinrichtung 68 erstreckenden Zugangsöffnung 70 kann dennoch der in dem Außenvolumen der Halbleitervorrichtung vorherrschende Druck p zu der mikromechanischen Einrichtung 66 des mikromechanischen Bauteils 50 geleitet werden.

Das mikromechanische Bauteil 50 kann zumindest ein strukturiertes oder unstrukturiertes Substrat 72 und 74 haben, das jeweils mindestens ein Halbleitermaterial, wie speziell Silizium, umfasst. Vorzugsweise ist das mikromechanische Bauteil 50 derart in der durchgehenden Öffnung 60 angeordnet ist, dass mindestens eine Außenfläche des zumindest einen Substrats 72 und 74 des mikromechanischen Bauteils 50 die mindestens eine Seitenwand 60a der durchgehenden Öffnung 60 mechanisch kontaktiert. Dies ist vorteilhaft, weil die auf die mindestens eine Außenfläche des zumindest einen Substrats 72 und 74 aufgespritzte Moldmasse in der Regel einen luft- und gasdichten mechanischen Kontakt mit der mindestens einen davon kontaktierten Außenfläche bildet.

Lediglich beispielhaft weist das in der durchgehenden Öffnung 60 angeordnete mikromechanische Bauteil 50 der Halbleitervorrichtung der Fig. 2 auf einer zu der Aussparung 56 und dem Deckel 54 ausgerichteten Seite seiner mikromechanischen Einrichtung 66 einen an einem ersten Substrat 72 angeordneten Funktionsschichtaufbau 76 auf, in welcher z.B. die mindestens eine verwölbbare Membran 62 und die mindestens eine Gegenelektrode 64 ausgebildet sind. Mindestens ein den Funktionsschichtaufbau 76 zumindest teilweise freistellender Hohlraum 72a und/oder mindestens ein Durchkontakt 72b können an dem ersten Substrat 72 ausgebildet sein. Auf einer zu der Aussparung 56 und dem Deckel 54 ausgerichteten Seite der anwendungsspezifischen Schaltungseinrichtung 68 der Halbleitervorrichtung der Fig. 2 liegt ein auf einem zweiten Substrat 74 ausgebildeter Schaltungsschichtaufbau 78. Auch durch das zweite Substrat 74 kann mindestens ein Durchkontakt 74a verlaufen. Die mikromechanische Einrichtung 66 und die anwendungsspezifische Schaltungseinrichtung 68 können über mindestens eine Bond-Verbindung aneinander befestigt sein. Optionaler Weise kann noch mindestens ein Lötball 80 auf einer von der Aussparung 56 und dem Deckel 54 weg gerichteten Bauteilaußenfläche 50b des mikromechanischen Bauteils 50 angebracht sein.

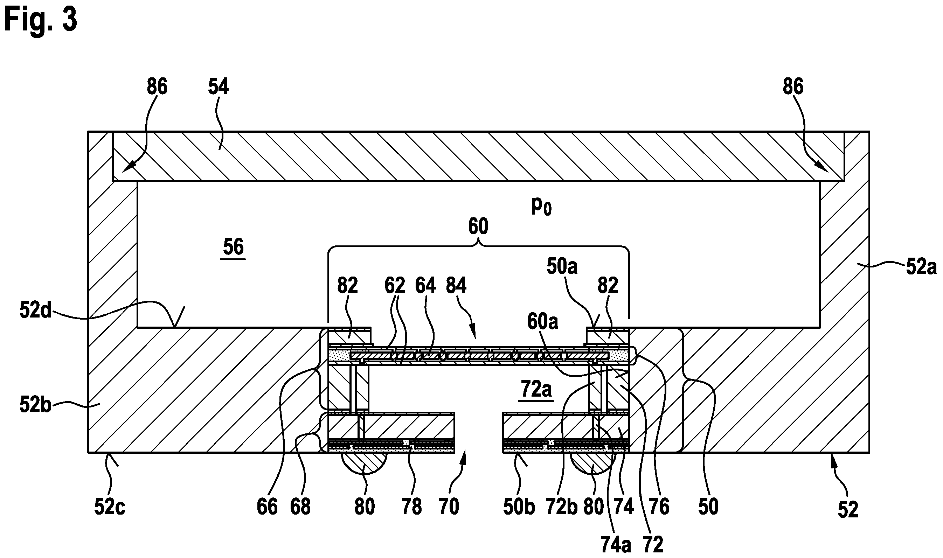

Fig. 3 zeigt eine schematische Darstellung einer zweiten Ausführungsform der Halbleitervorrichtung.

Bei der in Fig. 3 schematisch wiedergegebenen Halbleitervorrichtung weist das in der durchgehenden Öffnung 60 angeordnete mikromechanische Bauteil 50 als vorteilhafte Weiterbildung gegenüber der vorausgehend beschriebenen Ausführungsform noch einen Abstandshalter 82 auf, welcher an einem zu der Aussparung 56 und zu dem Deckel 54 ausgerichteten Ende des mikromechanischen Bauteils 50 liegt. Auch mindestens eine Abstandshalterseitenfläche des Abstandshalters 80 kann von der mindestens einen Seitenwand 60a der durchgehenden Öffnung 60 mechanisch kontaktiert sein. Evtl. kann mindestens eine Zugangsöffnung 84 an dem Abstandshalter 82 ausgebildet sein, mittels welcher z.B. die mikromechanische Einrichtung 66 des mikromechanischen Bauteils 50 zumindest teilweise von dem Abstandshalter 82 freigehalten/freigelegt ist. Der Abstandshalter 82 kann beispielsweise als ringförmigen Abstandshalter 82 ausgebildet sein. Insbesondere kann der Abstandshalter 82 aus einem auf dem Funktionsschichtaufbau 76 abgeschiedenen Material gebildet sein.

Der Abstandshalter 82 ermöglicht eine verglichen mit der Bodeninnenfläche 52d zurückversetzte Anordnung der mikromechanischen Einrichtung 66 des mikromechanischen Bauteils 50 innerhalb der Öffnung 60. Wie anhand des unten beschriebenen Herstellungsverfahrens deutlich wird, kann auf diese Weise verhindert werden, dass die mikromechanische Einrichtung 66 des mikromechanischen Bauteils 50, speziell die mindestens eine verwölbbare Membran 62, während des Moldvorgangs/Spritzgussgießens des Spritzgusskörpers 52 in einen Kontakt mit einem dazu mitverwendeten Stempel kommt. Die hier beschriebene Halbleitervorrichtung kann deshalb auch bei einer Ausstattung ihres mikromechanischen Bauteils 50 mit mindestens einer vergleichsweise empfindlichen verwölbbaren Membran 62 noch relativ kostengünstig und einfach hergestellt werden.

Als weitere optionale Weiterbildung ist an einem von dem Bodenbereich 52b weg gerichteten Ende des Seitenwandbereichs 52a des Spritzgusskörpers 52 der Halbleitervorrichtung der Fig. 3 noch eine Nut 86 ausgebildet, in welche der Deckel 54 eingeklemmt ist. Eine zum Befestigen des Deckels 54 an dem Spritzgusskörper 52 notwendige Klebemenge kann mittels der Ausbildung der Nut 86 reduziert sein. Insbesondere kann die Nut 86 auch ein Befestigen des Deckels 54 am Spritzgusskörper 52 ohne Verwendung eines Klebers ermöglichen. Die Ausbildung der Nut 86 an dem Seitenwandbereich 52a des Spritzgusskörpers 52 steigert außerdem eine Stabilität und eine Robustheit der realisierten Halbleitervorrichtung.

Bezüglich weiterer Eigenschaften und Merkmale der Halbleitervorrichtung der Fig. 3 und ihrer Vorteile wird auf die zuvor erläuterte Ausführungsform der Fig. 2 verwiesen.

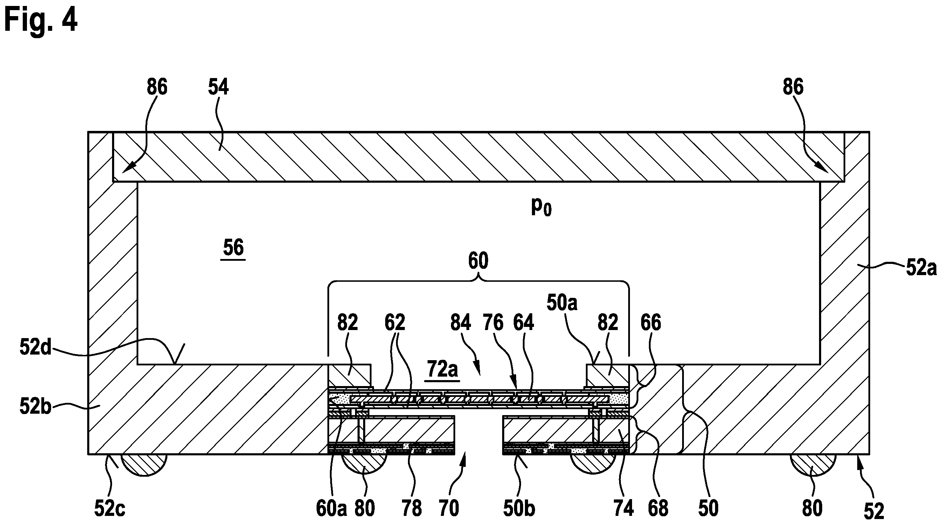

Fig. 4 zeigt eine schematische Darstellung einer dritten Ausführungsform der Halbleitervorrichtung.

Wie anhand der Fig. 4 erkennbar ist, kann der Abstandshalter 82 auch aus dem zumindest einen Substrat 72 und 74 des mikromechanischen Bauteils 50, speziell aus dem ersten Substrat 72 der mikromechanischen Einrichtung 66, herausstrukturiert sein. Gegebenenfalls können die mikromechanische Einrichtung 66 und die anwendungsspezifische Schaltungseinrichtung 68 auch über mindestens eine zwischen dem Funktionsschichtaufbau 76 und dem zweiten Substrat 74 der anwendungsspezifischen Schaltungseinrichtung 68 ausgebildeten Bond-Verbindung aneinander befestigt sein.

Sofern gewünscht, kann noch mindestens ein Lötball 80 auf der von der Aussparung 56 weg gerichteten Bodenaußenfläche 52c des Bodenbereichs 52b angebracht sein.

Bezüglich weiterer Eigenschaften und Merkmale der Halbleitervorrichtung der Fig. 4 und ihrer Vorteile wird auf die Ausführungsformen der Fig. 2 und 3 verwiesen.

Alle oben erläuterten Halbleitervorrichtungen sind aufgrund ihrer hohen Empfindlichkeit mit einem sehr geringen Stromverbrauch betreibbar. Lediglich beispielhaft sind die mikromechanischen Bauteile 50 der oben erläuterten Halbleitervorrichtungen als Drucksensor/kapazitiver Drucksensor, als Schallsensor, wie insbesondere als Körperschallsensor, oder als Mikrofon ausgebildet. Ein mikromechanisches Bauteil 50 einer derartigen Halbleitervorrichtung kann jedoch auch einen Inertialsensor und/oder einen chemischen Nachweissensor umfassen. Es wird nochmals darauf hingewiesen, dass die Herstellung der oben erläuterten Halbleitervorrichtungen kein teures und anfälliges Einkleben des jeweiligen mikromechanischen Bauteils 50 in den zugeordneten Spritzgusskörper 52 erfordert. Ein Auftreten von akustischen Leckpfaden ist durch das gute Aufbaukonzept der jeweiligen Halbleitervorrichtung (nahezu) ausgeschlossen. Außerdem kann jede der Halbleitervorrichtungen ihre Aussparung 56 als relativ großes Referenzvolumen nutzen. Eine Steigerung der als Referenzvolumen genutzten Aussparung 56 trägt kaum zur Kostensteigerung beim Herstellen der jeweiligen Halbleitervorrichtung bei. Wie außerdem erkennbar ist, können die anwendungsspezifische Schaltungseinrichtung 62 und die mikromechanische Einrichtung unabhängig von der Größe der als Referenzvolumen genutzten Aussparung 56 ausgebildet sein.

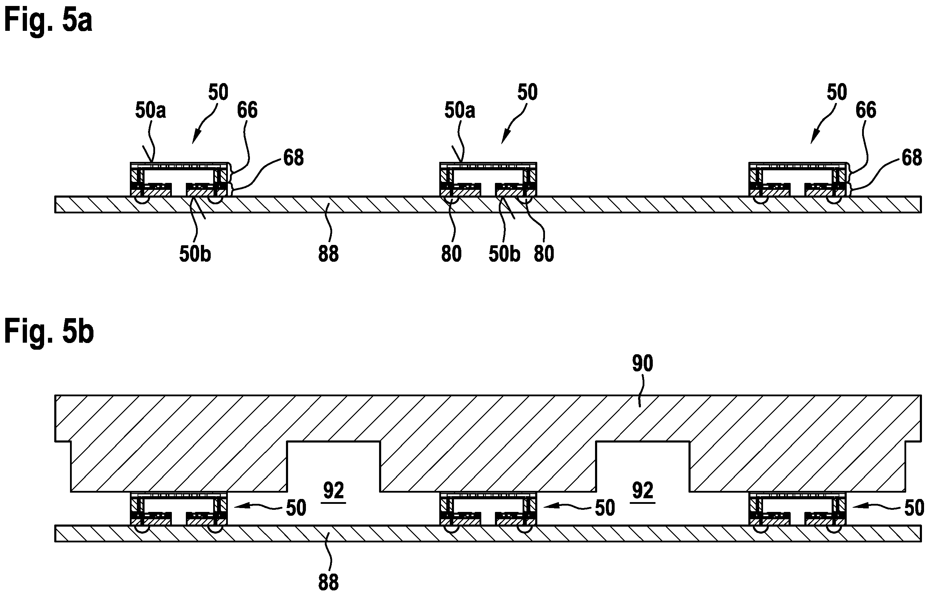

Fig. 5a bis 5f zeigen schematische Darstellungen von Zwischenprodukten zum Erläutern einer Ausführungsform des Herstellungsverfahrens für eine Halbleitervorrichtung.

Mittels des im Weiteren beschriebenen Herstellungsverfahrens können insbesondere die oben erläuterten Ausführungsformen von Halbleitervorrichtungen produziert werden. Es wird jedoch darauf hingewiesen, dass eine Ausführbarkeit des Herstellungsverfahrens nicht auf eine derartige Halbleitervorrichtung beschränkt ist.

Bei dem hier beschriebenen Herstellungsverfahren wird für mindestens ein mikromechanisches Bauteil 50 je ein Spritzgusskörper 52 gebildet. Wie anhand der Fig. 5a erkennbar ist, kann das Herstellungsverfahren auch auf Waferlevel ausgeführt werden, um für eine Vielzahl von mikromechanischen Bauteilen 50 den je einen Spritzgusskörper 52 zu formen. Indem alle Herstellungsschritte des im Weiteren beschriebenen Herstellungsverfahrens für die Vielzahl von mikromechanischen Bauteilen 50 gleichzeitig parallel/in einem Ensemble ausgeführt werden, können die auf diese Weise produzierten Halbleitervorrichtungen kostengünstig hergestellt werden.

Optionaler Weise kann auch die Vielzahl von mikromechanischen Bauteilen 50 auf Waferlevel produziert werden, obwohl dies in Fig. 5a nicht bildlich wiedergegeben ist. Beispielsweise können eine Vielzahl von mikromechanischen Einrichtungen 66 der mikromechanischen Bauteile 50 in einem ersten Wafer und eine Vielzahl von anwendungsspezifischen Schaltungseinrichtungen 68 der mikromechanischen Bauteile 50 in einem zweiten Wafer hergestellt werden. Sofern gewünscht, kann noch mindestens ein Lötball 80 auf einer späteren Bauteilaußenfläche 50b jedes mikromechanischen Bauteils 50 aufgebracht werden.

Anschließend kann der erste Wafer mit dem zweiten Wafer so gebondet werden, dass für jedes der mikromechanischen Bauteile 50 die zugeordnete anwendungsspezifische Schaltungseinrichtung 68 und die zugeordnete mikromechanische Einrichtung zusammengefügt werden. Der auf diese Weise gewonnene Waferstack kann anschließend vereinzelt werden, wobei vor dem Vereinzeln des Waferstacks an den mikromechanischen Bauteilen 50 evtl. ausgebildete Öffnungen/Spalten mit einer Sägefolie abgedeckt werden können, sodass kein Sägestaub ins Innere der vereinzelten mikromechanischen Bauteile 50 eindringen kann. Zum Vereinzeln der mikromechanischen Bauteile 50 kann deshalb auch ein konventioneller Sägeprozess ausgeführt werden.

Die aus dem Waferstack herausgetrennten mikromechanischen Bauteile 50 werden auf einer Unterlage 88 angeordnet, wie in Fig. 5a bildlich wiedergegeben ist. Die Unterlage 88 kann ein Träger 88 oder eine Folie 88 sein, welche die mikromechanischen Bauteile 50 beim späteren Umspritzen der mikromechanischen Bauteile 50 festhält und gleichzeitig an den mikromechanischen Bauteilen 50 evtl. ausgebildete Öffnungen/Spalten gegen das Eindringen von Moldmasse abdeckt. Alternativ können die mikromechanischen Bauteile 50 auch auf ein Laminat als Unterlage 88 gelötet werden. Gegebenenfalls können an den mikromechanischen Bauteilen 50 evtl. ausgebildete Öffnungen/Spalten auch mit einem sogenannten Underfill, d.h. mit einer Vergussmasse, welche aufgrund von Kapillarkräften lediglich auf der von der Unterlage 88 kontaktierten Bauteilaußenfläche 50b jedes mikromechanischen Bauteils 50 fließt, geschützt werden.

In einem in Fig. 5b bildlich wiedergegebenen Verfahrensschritt wird die Unterlage 88 mit den vereinzelten mikromechanischen Bauteilen 50 in eine (nicht dargestellte) Moldpresse eingebracht, wobei auf einer von der Unterlage 88 weg gerichteten Seite ein Stempel 90 gegen die mikromechanischen Bauteile 50 gedrückt wird. Als vorteilhafte Weiterbildung kann vor einem Umspritzen des mindestens einen mikromechanischen Bauteils 50 mit einer Moldmasse seines späteren Spritzgrusskörpers 52 ein (nicht dargestellter) Film zwischen dem Stempel 90 und dem mindestens einen mikromechanischen Bauteil 50 angeordnet werden. Mittels der Mitverwendung des Films zusammen mit der Unterlage 88 und dem Stempel 90 ist ein Toleranzausgleich erzielbar.

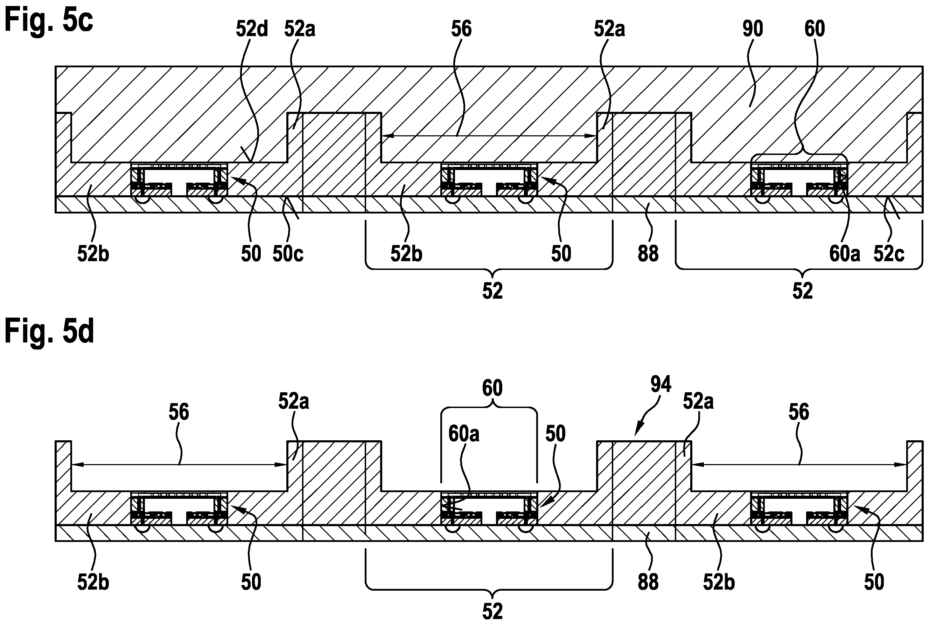

Der Stempel 90 ist so geformt, dass ein zwischen der Unterlage 88 und dem mit oder ohne Film gegen das mindestens eine mikromechanische Bauteil 50 gedrückten Stempel 90 vorliegender Freiraum 92 eine gewünschte Form des mindestens einen anschließend gebildeten Spritzgusskörpers 52 des mindestens einen mikromechanischen Bauteils 50 wiedergibt. Wir in Fig. 5c erkennbar, kann anschließend zum Bilden des mindestens einen Spritzgusskörpers 52 des mindestens einen mikromechanischen Bauteils 50 ein Moldverfahren ausgeführt werden, bei welchem das mindestens eine mikromechanische Bauteil 50 unter Verwendung des Stempels 90 mit der Moldmasse des mindestens einen späteren Spritzgusskörpers 52 umspritzt wird. Wie oben bereits erläutert ist, kann das Moldverfahren insbesondere als "Filmmolden" ausgeführt werden, indem mittels des Films zwischen dem Stempel 90 und dem mindestens einen mikromechanischen Bauteil 50 ein Toleranzausgleich erreicht und zusätzlich die jeweilige Oberfläche des mindestens einen mikromechanischen Bauteils 50 geschützt wird.

Bei dem Moldverfahren wird aufgrund der Form des Stempels 90 der mindestens eine spätere Spritzgusskörper 52 mit je einer Aussparung 56 geformt, welche von einem Seitenwandbereich 52a des jeweils umgebenden Spritzgusskörpers 52 umrahmt wird, während auf einer ersten Seite der jeweiligen Aussparung 56 die Aussparung 56 zumindest teilflächig von einem Bodenbereich 52b des späteren Spritzgusskörpers 52 abgedeckt wird. Außerdem wird beim Bilden des jeweiligen Spritzgusskörpers 52 des mindestens einen mikromechanischen Bauteils 50 das jeweilige mikromechanische Bauteil 50 derart von der Moldmasse umhüllt, dass je eine durchgehende Öffnung 60 an dem Bodenbereich 52b des jeweiligen Spritzgusskörpers 52 ausgebildet wird. Weil das mindestens eine mikromechanische Bauteil 50 während des Moldverfahrens mittels des Stempels 90 mit oder ohne den Film gegen die Unterlage 88 gedrückt wird, wird die in dem Bodenbereich 52b seines Spritzgusskörpers 52 ausgebildete durchgehende Öffnung 60 mit mindestens einer Seitenwand 60a geformt, welche sich von der in dem jeweiligen Spritzgusskörper 52 ausgebildeten Aussparung 56 bis zu einer von der Aussparung 56 weg gerichteten Bodenaußenfläche 52c des auf diese Weise gebildeten späteren Bodenbereichs 52b erstreckt. Zusätzlich wird bei dem Moldverfahren das mindestens eine mikromechanische Bauteil 50 derart in der durchgehenden Öffnung 60 seines späteren Spritzgusskörpers 52 angeordnet, dass das mindestens eine mikromechanische Bauteil 50 die mindestens eine Seitenwand 60a der in seinem Spritzgusskörper 52 ausgebildeten durchgehenden Öffnung 60 mechanisch kontaktiert.

Anschließend kann die Moldpresse geöffnet und die Unterlage 88 mit dem darauf angeordneten mindestens einen mikromechanischen Bauteil 50 mit seinem jeweils gebildeten Spritzgusskörper 52 aus der Moldpresse entnommen werden. Evtl. kann nach dem Umspritzen des mindestens einen mikromechanischen Bauteils 50 mit der Moldmasse und einem Abnehmen des nun nicht mehr benötigten Stempels 90 der Film von dem mindestens einen umspritzten mikromechanischen Bauteil 50 entfernt werden.

Das Zwischenprodukt ist in Fig. 5d bildlich wiedergegeben. Erkennbar ist, dass bei einem Spritzgussgießen zum Bilden einer Vielzahl von späteren Spritzgusskörpern 52 die geformten Spritzgusskörper 52 noch in einem Spritzgusskörperverbund 94 zusammenhängen können.

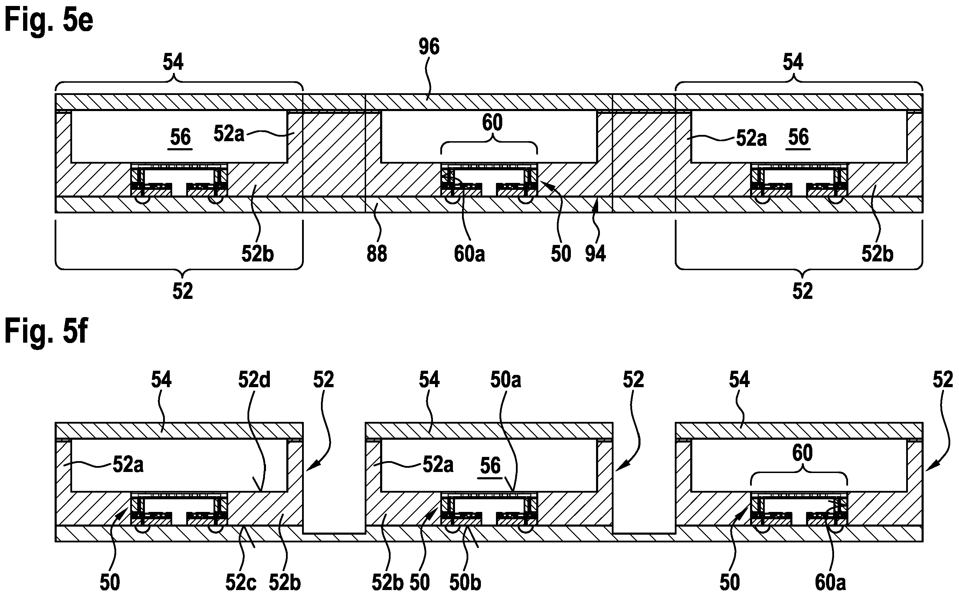

Anschließend wird mindestens ein Deckel 54 auf einer von der ersten Seite der mindestens einen Aussparung 56 weg gerichteten zweiten Seite der mindestens einen Aussparung 56 direkt oder über mindestens eine Zwischenkomponente 58 an dem jeweiligen Seitenwandbereich 52a des mindestens einen späteren Spritzgusskörpers 52 so befestigt, dass der mindestens eine Deckel 54 die ihm zugeordnete Aussparung 56 auf ihrer zweiten Seite abdeckt. Kostengünstiger Weise kann der mindestens eine Deckel 54 direkt und flächig auf den ihm zugeordneten Spritzgusskörper 52 aufgeklebt werden. Vorzugsweise wird eine Vielzahl von Deckeln 54 als flächige Platte 96 auf den die Vielzahl von Spritzgusskörpern 52 umfassenden Spritzgusskörperverbund 94 aufgebracht. Das auf diese Weise gewonnene Zwischenprodukt ist in Fig. 5e gezeigt. Bei dem Stack aus der flächigen Platte 96 mit der Vielzahl von Deckeln 54 und aus dem die Vielzahl von Spritzgusskörpern 52 umfassenden Spritzgusskörperverbund 94 hängen die späteren Halbleitervorrichtung noch zusammen.

In Fig. 5f ist das Vereinzeln der im Waferverbund hergestellten Halbleitervorrichtungen bildlich wiedergegeben. Zum Vereinzeln kann ein konventioneller Sägeprozess ausgeführt werden, während welchem das mikromechanische Bauteil 50 und die Aussparung 56 jeder vereinzelten Halbleitervorrichtung aufgrund von seinem (mit-) herausgetrennten Deckel 54 und seinem (mit-) herausgetrennten Spritzgusskörper 52 gut vor einem unerwünschten Eindringen von Sägestaub geschützt sind.

## Patentansprüche

1. Halbleitervorrichtung mit
einem mikromechanischen Bauteil (50);
einem Spritzgusskörper (52) mit zumindest einer an dem Spritzgusskörper (52) ausgebildeten Aussparung (56), welche von einem Seitenwandbereich (52a) des Spritzgusskörpers (52) umrahmt ist und auf einer ersten Seite der Aussparung (56) zumindest teilflächig von einem Bodenbereich (52b) des Spritzgusskörpers (52) abgedeckt ist; und
einem Deckel (54), welcher auf einer von der ersten Seite der Aussparung (56) weg gerichteten zweiten Seite der Aussparung (56) direkt oder über mindestens eine Zwischenkomponente (58) an dem Seitenwandbereich (52a) befestigt ist und die Aussparung (56) auf ihrer zweiten Seite abdeckt;
wobei an dem Bodenbereich (52b) des Spritzgusskörpers (52) eine durchgehende Öffnung (60) ausgebildet ist, deren mindestens eine Seitenwand (60a) sich von der Aussparung (56) bis zu einer von der Aussparung (56) weg gerichteten Bodenaußenfläche (52c) des Bodenbereichs (52b) erstreckt;
und
das mikromechanische Bauteil (50) derart in der durchgehenden Öffnung (60) angeordnet ist, dass das mikromechanische Bauteil (50) die mindestens eine Seitenwand (60a) der durchgehenden Öffnung (60) mechanisch kontaktiert.

2. Halbleitervorrichtung nach Anspruch 1, wobei das mikromechanische Bauteil (50) zumindest ein strukturiertes oder unstrukturiertes Substrat (72, 74) aufweist, das mindestens ein Halbleitermaterial umfasst, und wobei das mikromechanische Bauteil (50) derart in der durchgehenden Öffnung (60) angeordnet ist, dass mindestens eine Außenfläche des zumindest einen Substrats (72, 74) des mikromechanischen Bauteils (50) die mindestens eine Seitenwand (60a) der durchgehenden Öffnung (60) mechanisch kontaktiert.

3. Halbleitervorrichtung nach Anspruch 1 oder 2, wobei die Aussparung (56) auf ihrer ersten Seite von dem Bodenbereich (52b) des Spritzgusskörpers (52) und von dem in der durchgehenden Öffnung (60) angeordneten mikromechanischen Bauteil (50) abgedeckt ist.

4. Halbleitervorrichtung nach einem der vorhergehenden Ansprüche, wobei der Deckel (54) luft- und gasdicht direkt oder über die mindestens eine Zwischenkomponente (58) an dem Seitenwandbereich (52a) befestigt ist und der mechanische Kontakt der mindestens einen Seitenwand (60a) der durchgehenden Öffnung (60) mit dem mikromechanischen Bauteil (50) luft- und gasdicht ist, wodurch die Aussparung (56) mittels des Spritzgusskörpers (52), des Deckels (54) und des mikromechanischen Bauteils (50) luft- und gasdicht gegenüber einem Außenvolumen der Halbleitervorrichtung abgedichtet ist.

5. Halbleitervorrichtung nach Anspruch 4, wobei das in der durchgehenden Öffnung (60) angeordnete mikromechanische Bauteil mindestens eine verwölbbare Membran (62) aufweist, auf deren jeweilige erste Membranoberfläche (62a) ein in dem Außenvolumen vorherrschender Druck (p) und auf deren von der ersten Membranoberfläche (62a) weg gerichtete jeweilige zweite Membranoberfläche (62b) ein in der Aussparung (56) eingeschlossener Referenzdruck (p₀) einwirken.

6. Halbleitervorrichtung nach einem der vorhergehenden Ansprüche, wobei das in der durchgehenden Öffnung (60) angeordnete mikromechanische Bauteil (50) an seinem zu der Aussparung (56) ausgerichteten Ende einen Abstandshalter (82) aufweist, und wobei mindestens eine Abstandshalterseitenfläche des Abstandshalters (82) die mindestens eine Seitenwand (60a) der durchgehenden Öffnung (60) mechanisch kontaktiert.

7. Halbleitervorrichtung nach einem der vorhergehenden Ansprüche, wobei das in der durchgehenden Öffnung (60) angeordnete mikromechanische Bauteil (50) eine anwendungsspezifische Schaltungseinrichtung (68) aufweist, und wobei mindestens eine Seitenfläche der anwendungsspezifischen Schaltungseinrichtung (68) die mindestens eine Seitenwand (60a) der durchgehenden Öffnung (60) mechanisch kontaktiert.

8. Halbleitervorrichtung nach einem der vorhergehenden Ansprüche, wobei die Halbleitervorrichtung ein Drucksensor, ein Schallsensor oder ein Mikrofon ist.

9. Herstellungsverfahren für eine Halbleitervorrichtung mit den Schritten:
Bilden eines Spritzgusskörpers (52) für ein mikromechanisches Bauteil (50) mit einer an dem Spritzgusskörper (52) ausgebildeten Aussparung (56), welche von einem Seitenwandbereich (52a) des Spritzgusskörpers (52) umrahmt wird und auf einer ersten Seite der Aussparung (56) zumindest teilflächig von einem Bodenbereich (52b) des Spritzgusskörpers (52) abgedeckt wird; und
Befestigen eines Deckels (54) auf einer von der ersten Seite der Aussparung (56) weg gerichteten zweiten Seite der Aussparung (56) direkt oder über mindestens eine Zwischenkomponente (58) an dem Seitenwandbereich (52a) so, dass der Deckel (54) die Aussparung (56) auf ihrer zweiten Seite abdeckt;
wobei beim Bilden des Spritzgusskörpers (52) eine durchgehende Öffnung (60) an dem Bodenbereich (52b) des Spritzgusskörpers (52) ausgebildet wird, deren mindestens eine Seitenwand (60a) sich von der Aussparung (56) bis zu einer von der Aussparung (56) weg gerichteten Bodenaußenfläche (52c) des Bodenbereichs (52b) erstreckt, und das mikromechanische Bauteil (50) derart in der durchgehenden Öffnung (60) angeordnet wird, dass das mikromechanische Bauteil (50) die mindestens eine Seitenwand (60a) der durchgehenden Öffnung (60) mechanisch kontaktiert.

10. Herstellungsverfahren nach Anspruch 9, wobei zum Bilden des Spritzgusskörpers (52) das mikromechanische Bauteil (50) unter Verwendung eines Stempels (90) mit einer Moldmasse des späteren Spritzgusskörpers (52) umspritzt wird.

11. Herstellungsverfahren nach Anspruch 10, wobei vor dem Umspritzen des mikromechanischen Bauteils (50) mit der Moldmasse des späteren Spritzgusskörpers (52) ein Film zwischen dem Stempel (90) und dem mikromechanischen Bauteil (50) angeordnet wird, welcher nach dem Umspritzen des mikromechanischen Bauteils (50) mit der Moldmasse und einem Abnehmen des Stempels (90) von dem umspritzten mikromechanischen Bauteil (50) entfernt wird.

## Claims

1. Semiconductor device with
a micromechanical component (50);
an injection-moulded body (52) with at least one recess (56) formed on the injection-moulded body (52), the recess being framed by a side-wall region (52a) of the injection-moulded body (52) and being at least partially covered on a first side of the recess (56) by a base region (52b) of the injection-moulded body (52); and
a cover (54), which is fastened to the side-wall region (52a) directly or via at least one intermediate component (58) on a second side of the recess (56), facing away from the first side of the recess (56), and covers the recess (56) on its second side;
wherein a through-opening (60) is formed at the base region (52b) of the injection-moulded body (52) with at least one side wall (60a) thereof extending from the recess (56) to a base outer surface (52c) of the base region (52b) directed away from the recess (56), and
the micromechanical component (50) is arranged in the through-opening (60) in such a way that the micromechanical component (50) mechanically contacts the at least one side wall (60a) of the through-opening (60).

2. Semiconductor device according to Claim 1, wherein the micromechanical component (50) has at least one structured or unstructured substrate (72, 74), which comprises at least one semiconductor material, and wherein the micromechanical component (50) is arranged in the through-opening (60) such that at least one outer surface of the at least one substrate (72, 74) of the micromechanical component (50) mechanically contacts the at least one side wall (60a) of the through-opening (60).

3. Semiconductor device according to Claim 1 or 2, wherein the recess (56) is covered on its first side by the base region (52b) of the injection-moulded body (52) and by the micromechanical component (50) arranged in the through-opening (60).

4. Semiconductor device according to one of the preceding claims, wherein the cover (54) is fastened to the side-wall region (52a) in an air-tight and gas-tight manner directly or via the at least one intermediate component (58), and the mechanical contact of the at least one side wall (60a) of the through-opening (60) with the micromechanical component (50) is air-tight and gas-tight, whereby the recess (56) is sealed in an air-tight and gas-tight manner with respect to an outer volume of the semiconductor device by means of the injection-moulded body (52), the cover (54) and the micromechanical component (50).

5. Semiconductor device according to Claim 4, wherein the micromechanical component arranged in the through-opening (60) has at least one deformable membrane (62), on the respective first membrane surface (62a) of which a pressure (p) prevailing in the outer volume acts, and on the respective second membrane surface (62b) of which, facing away from the first membrane surface (62a), a reference pressure (p₀) enclosed in the recess (56) acts.

6. Semiconductor device according to one of the preceding claims, wherein the micromechanical component (50) arranged in the through-opening (60) has a spacer (82) at its end aligned with the recess (56), and wherein at least one spacer side surface of the spacer (82) mechanically contacts the at least one side wall (60a) of the through-opening (60).

7. Semiconductor device according to one of the preceding claims, wherein the micromechanical component (50) arranged in the through-opening (60) has an application-specific circuit device (68), and wherein at least one side surface of the application-specific circuit device (68) mechanically contacts the at least one side wall (60a) of the through-opening (60).

8. Semiconductor device according to one of the preceding claims, wherein the semiconductor device is a pressure sensor, a sound sensor or a microphone.

9. Production method for a semiconductor device, comprising the following steps:
forming an injection-moulded body (52) for a micromechanical component (50) with a recess (56) formed on the injection-moulded body (52), the recess being framed by a side-wall region (52a) of the injection-moulded body (52) and being at least partially covered on a first side of the recess (56) by a base region (52b) of the injection-moulded body (52); and
fastening a cover (54) to the side-wall region (52a) directly or via at least one intermediate component (58) on a second side of the recess (56), facing away from the first side of the recess (56), such that the cover (54) covers the recess (56) on its second side;
wherein, during the formation of the injection-moulded body (52), a through-opening (60) is formed at the base region (52b) of the injection-moulded body (52) with at least one side wall (60a) thereof extending from the recess (56) to a base outer surface (52c) of the base region (52b) directed away from the recess (56), and the micromechanical component (50) is arranged in the through-opening (60) in such a way that the micromechanical component (50) mechanically contacts the at least one side wall (60a) of the through-opening (60).

10. Production method according to Claim 9, wherein, to form the injection-moulded body (52), the micromechanical component (50) is overmoulded with a moulding compound of the subsequent injection-moulded body (52) using a core pin (90).

11. Production method according to Claim 10, wherein, before the micromechanical component (50) is overmoulded with the moulding compound of the subsequent injection-moulded body (52), a film is arranged between the core pin (90) and the micromechanical component (50), and the film is removed after the micromechanical component (50) has been overmoulded with the moulding compound and the core pin (90) has been removed from the overmoulded micromechanical component (50).

## Revendications

1. Arrangement semiconducteur comprenant
un composant micromécanique (50) ;
un corps moulé par injection (52) comprenant au moins un évidement (56) formé sur le corps moulé par injection (52), lequel est encadré par une zone de paroi latérale (52a) du corps moulé par injection (52) et est recouvert sur un premier côté de l'évidement (56), au moins sur une surface partielle, par une zone de fond (52b) du corps moulé par injection (52) ; et
un couvercle (54), lequel est fixé sur un deuxième côté de l'évidement (56) opposé au premier côté de l'évidement (56), directement ou par le biais d'au moins un composant intermédiaire (58) au niveau de la zone de paroi latérale (52a), et recouvre l'évidement (56) sur son deuxième côté ;
une ouverture traversante (60) étant formée au niveau de la zone de fond (52b) du corps moulé par injection (52), dont l'au moins une paroi latérale (60a) s'étend de l'évidement (56) jusqu'à une surface extérieure de fond (52c) de la zone de fond (52b) qui est orientée à l'opposé de l'évidement (56) ; et
le composant micromécanique (50) étant disposé dans l'ouverture traversante (60) de telle sorte que le composant micromécanique (50) entre mécaniquement en contact avec l'au moins une paroi latérale (60a) de l'ouverture traversante (60).

2. Arrangement semiconducteur selon la revendication 1, le composant micromécanique (50) possédant au moins un substrat (72, 74) structuré ou non structuré, qui comprend au moins un matériau semiconducteur, et le composant micromécanique (50) étant disposé dans l'ouverture traversante (60) de telle sorte qu'au moins une surface extérieure de l'au moins un substrat (72, 74) du composant micromécanique (50) entre mécaniquement en contact avec l'au moins une paroi latérale (60a) de l'ouverture traversante (60).

3. Arrangement semiconducteur selon la revendication 1 ou 2, l'évidement (56) étant recouvert sur son premier côté par la zone de fond (52b) du corps moulé par injection (52) et par le composant micromécanique (50) disposé dans l'ouverture traversante (60).

4. Arrangement semiconducteur selon l'une des revendications précédentes, le couvercle (54) étant fixé à la zone de paroi latérale (52a) de manière étanche à l'air et au gaz directement ou par l'intermédiaire de l'au moins un composant intermédiaire (60) et le contact mécanique de l'au moins une paroi latérale (60a) de l'ouverture traversante (58) avec le composant micromécanique (50) étant étanche à l'air et au gaz, moyennant quoi l'évidement (56) est rendu étanche à l'air et aux gaz par rapport à un volume extérieur de l'arrangement semiconducteur au moyen du corps moulé par injection (52), du couvercle (54) et du composant micromécanique (50).

5. Arrangement semiconducteur selon la revendication 4, le composant micromécanique disposé dans l'ouverture traversante (60) possédant au moins une membrane (62) gauchissable, une pression (p) régnant dans le volume extérieur agissant sur sa première surface de membrane (62a) respective et une pression de référence (p₀) confinée dans l'évidement (56) sur sa deuxième surface de membrane (62b) respective, orientée à l'opposé de la première surface de membrane (62a).

6. Arrangement semiconducteur selon l'une des revendications précédentes, le composant micromécanique (50) disposé dans l'ouverture traversante (60) possédant une entretoise (82) à son extrémité orientée vers l'évidement (56), et au moins une surface latérale d'entretoise de l'entretoise (82) entrant mécaniquement en contact avec l'au moins une paroi latérale (60a) de l'ouverture traversante (60).

7. Arrangement semiconducteur selon l'une des revendications précédentes, le composant micromécanique (50) disposé dans l'ouverture traversante (60) possédant un dispositif de circuit spécifique à l'application (68), et au moins une face latérale du dispositif de circuit spécifique à l'application (68) entrant mécaniquement en contact avec l'au moins une paroi latérale (60a) de l'ouverture traversante (60).

8. Arrangement semiconducteur selon l'une des revendications précédentes, l'arrangement semiconducteur étant un capteur de pression, un capteur de son ou un microphone.

9. Procédé de fabrication d'un arrangement semiconducteur, comprenant les étapes suivantes :
formation d'un corps moulé par injection (52) pour un composant micromécanique (50) comprenant au moins un évidement (56) formé sur le corps moulé par injection (52), lequel sera encadré par une zone de paroi latérale (52a) du corps moulé par injection (52) et sera recouvert sur un premier côté de l'évidement (56), au moins sur une surface partielle, par une zone de fond (52b) du corps moulé par injection (52) ; et
fixation d'un couvercle (54) sur un deuxième côté de l'évidement (56) opposé au premier côté de l'évidement (56), directement ou par le biais d'au moins un composant intermédiaire (58) au niveau de la zone de paroi latérale (52a), de telle sorte que le couvercle (54) recouvre l'évidement (56) sur son deuxième côté ;
lors de la formation du corps moulé par injection (52), une ouverture traversante (60) étant formée au niveau de la zone de fond (52b) du corps moulé par injection (52), dont l'au moins une paroi latérale (60a) s'étend de l'évidement (56) jusqu'à une surface extérieure de fond (52c) de la zone de fond (52b) orientée à l'opposé de l'évidement (56), et le composant micromécanique (50) étant disposé dans l'ouverture traversante (60) de telle sorte que le composant micromécanique (50) entre mécaniquement en contact avec l'au moins une paroi latérale (60a) de l'ouverture traversante (60).

10. Procédé de fabrication selon la revendication 9, en vue de former le corps moulé par injection (52), le composant micromécanique (50) étant surmoulé avec une masse de moulage du futur corps moulé par injection (52) en utilisant une matrice (90).

11. Procédé de fabrication selon la revendication 10, un film étant disposé entre la matrice (90) et le composant micromécanique (50) avant le surmoulage du composant micromécanique (50) avec la masse de moulage du futur corps moulé par injection (52), lequel est retiré après le surmoulage du composant micromécanique (50) avec la masse de moulage et un enlèvement de la matrice (90) du composant micromécanique (50) surmoulé.
